# DEMANDE DE BREVET EUROPEEN

(11) **EP 3 240 155 A1**
(43) Date de publication de la demande: **01.11.2017**
(21) Numéro de dépôt: 17168492.1
(22) Date de dépôt: 27.04.2017
(51) Int. Cl.: H02K 5/22, H02K 3/50, H02K 11/33, F02B 39/10, F04D 25/06

(54) **MODULE ÉLECTRONIQUE DE PUISSANCE, ENSEMBLE ÉLECTRIQUE ET COMPRESSEUR DE SURALIMENTATION ÉLECTRIQUE COMPRENANT UN TEL MODULE ÉLECTRONIQUE DE PUISSANCE**

(30) Priorité: 28.04.2016 FR 1653774
(71) Demandeur: Valeo Systemes de Controle Moteur, 95800 Cergy Saint Christophe (FR)
(72) Inventeur: HODEBOURG, Grégory, 95800 CERGY SAINT CHRISTOPHE (FR); DUCHON, Rudy, 95800 CERGY SAINT CHRISTOPHE (FR); LARABI, Lakhdar, 95800 CERGY SAINT CHRISTOPHE (FR)
(74) Mandataire: Cardon, Nicolas

(57) **Abrégé**

L'invention concerne un module électronique de puissance comprenant :
- une pluralité de puces semi-conductrices configurées pour commander et échanger une énergie électrique avec un équipement électrique extérieur au module électronique de puissance ;
- un boitier encapsulant lesdites puces semi-conductrices ;
- des conducteurs électriques (108u, 108v, 108w) configurés pour recevoir un courant électrique échangé entre les puces semi-conductrices et l'équipement électrique, lesdits conducteurs électriques ayant respectivement une première borne (109u, 109v, 109w, 509) à l'intérieur dudit boitier configurée pour être connectée à au moins une desdits puces semi-conductrices et une deuxième borne à l'extérieur dudit boitier configurée pour être connectée à l'équipement électrique ;
lesdits conducteurs électriques (108u, 108v, 108w) s'étendant à l'extérieur dudit boitier de sorte que les deuxièmes bornes sont alignées suivant une ligne courbe (Ω).

## Description

La présente invention concerne un module électronique de puissance, un ensemble électrique comprenant un module électronique de puissance selon l'invention, et un compresseur de suralimentation électrique comportant un ensemble électrique selon l'invention.

Dans le cadre de l'invention, un compresseur de suralimentation électrique est un dispositif, utilisé pour suralimenter un moteur thermique, et fonctionnant avec une machine électrique. Plus précisément, le compresseur comporte une roue de compresseur entrainée par la machine électrique. Typiquement, un compresseur de suralimentation électrique est placé sur la ligne d'admission d'air d'un moteur à combustion interne, notamment d'un véhicule, par exemple en complément d'un turbocompresseur. Le compresseur de suralimentation électrique joue le même rôle que le turbocompresseur, à savoir augmenter la pression d'admission des gaz frais dans le moteur à combustion interne, mais est utilisé notamment lors des phases transitoires pour palier aux problèmes de temps de réponse du turbocompresseur.

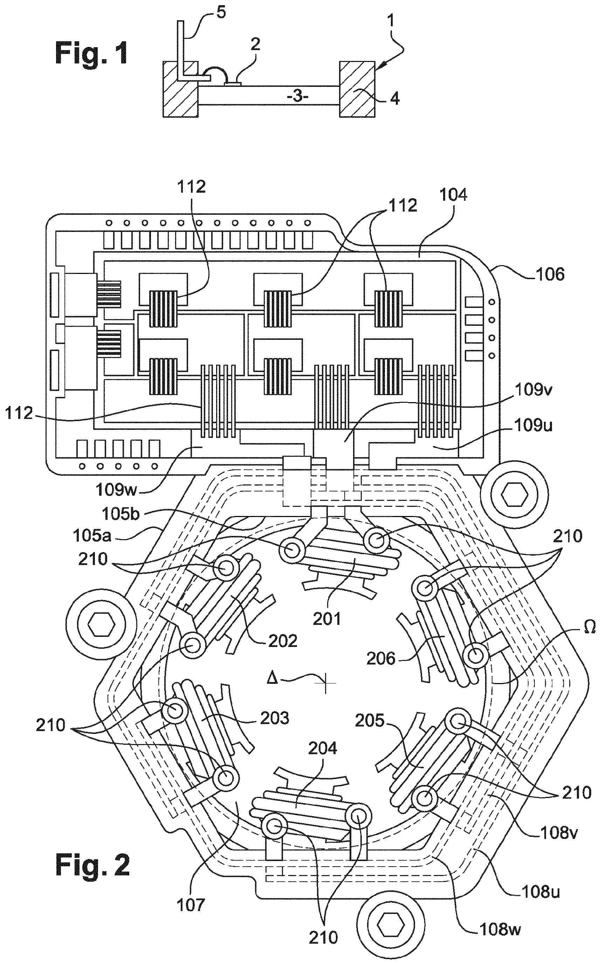

Un convertisseur de tension permet de commander l'énergie alimentant la machine électrique du compresseur. Il est connu d'intégrer ce convertisseur de tension dans le compresseur avec la machine électrique. Par exemple, la demande de brevet européenne EP 2 913 909 A1 décrit un tel compresseur de suralimentation électrique. Dans ce document, des interrupteurs électroniques destinés à recevoir une énergie électrique alimentant la machine électrique sont montés sur une carte électronique avec des composants de contrôle destinés à commander ces composants électroniques. Cependant, il peut être avantageux d'utiliser des interrupteurs électroniques préalablement intégrés dans un module électronique de puissance. Typiquement, un module électronique de puissance fournit un conditionnement physique à plusieurs puces semi-conductrices interconnectées entre elles selon un circuit électrique. La figure 1 illustre un exemple de module électronique de puissance 1 selon l'art antérieur. Le module électronique de puissance 1 comprend un substrat 3 sur lequel des interrupteurs 2 sont montés dans un agencement prédéfini. Le module électronique de puissance 1 peut avoir une ceinture 4 sur toute la périphérie du substrat 3 qui définit un logement interne recevant les interrupteurs 2. Ce logement interne peut être rempli de gel pour protéger les interrupteurs 2. Un conducteur électrique 5 surmoulé dans la ceinture 4 est destiné à assurer une liaison électrique entre l'intérieur et l'extérieur du module électronique de puissance 1.

Cependant, les bornes de phase de la machine électrique sont le plus souvent proches de l'axe de rotation de la machine et autour de celui-ci. Il peut être difficile de connecter les bornes de phases de la machine électrique à l'alimentation électrique fournie par les interrupteurs électroniques. En particulier, les connexions électriques entre la machine électrique et le module électronique de puissance peuvent être complexes à réaliser. Or, pour améliorer l'intégration du compresseur de suralimentation dans le véhicule, notamment avec le moteur à combustion interne, il est nécessaire de maitriser son encombrement et de faciliter son assemblage.

Il est donc recherché des composants présentant un agencement facilitant leur assemblage dans un ensemble électrique, notamment dans un compresseur de suralimentation électrique.

A cet effet, il est proposé un module électronique de puissance comprenant :
- une pluralité de puces semi-conductrices configurées pour commander et échanger une énergie électrique avec un équipement électrique extérieur au module électronique de puissance ;
- un boitier encapsulant lesdites puces semi-conductrices ;
- des conducteurs électriques configurés pour recevoir un courant électrique échangé entre les puces semi-conductrices et l'équipement électrique, lesdits conducteurs électriques ayant respectivement une première borne à l'intérieur dudit boitier configurée pour être connectée à au moins une desdits puces semi-conductrices et une deuxième borne à l'extérieur dudit boitier configurée pour être connectée à l'équipement électrique ;
lesdits conducteurs électriques s'étendant à l'extérieur dudit boitier de sorte que les deuxièmes bornes sont alignées suivant une ligne courbe.

Ainsi, lorsque le module électronique de puissance alimente un équipement électrique dont les bornes électriques sont agencées suivant la ligne courbe, les deuxièmes bornes peuvent venir contre les bornes de l'équipement électrique pour y être directement reliées et fournir ainsi un contact électrique entre le module électronique de puissance et l'équipement électrique. Les conducteurs électriques se connectent aux bornes de l'équipement électrique sans l'utilisation d'une pièce intermédiaire entre les deuxièmes bornes et les bornes de l'équipement électrique, ce qui diminue l'encombrement de l'ensemble qui comprend le module électronique de puissance.

Selon un mode de réalisation, les deuxièmes bornes de tous les conducteurs électriques configurés pour recevoir un courant électrique échangé entre les puces semi-conductrices et l'équipement électrique sont alignées suivant ladite ligne courbe.

Selon un mode de réalisation, le boitier comprend une excroissance s'étendant vers l'extérieur du module électronique de puissance et comprenant une portion respective des conducteurs électriques.

Selon un mode de réalisation, lesdites deuxièmes bornes s'étendent depuis une paroi de ladite excroissance, ladite paroi ayant une face s'étendant le long d'une ligne courbe ou ayant plusieurs faces tangentes à une ligne courbe.

Selon un mode de réalisation, l'excroissance s'étend principalement suivant un plan parallèle à une surface suivant laquelle les puces semi-conductrices sont montées.

Selon un mode de réalisation, les deuxièmes bornes comprennent respectivement une face destinée à venir en contact avec des bornes de l'équipement électrique, ladite face étant tangente à ladite ligne courbe suivant laquelle les deuxièmes bornes sont alignées.

Selon un mode de réalisation, les deuxièmes bornes sont alignées et régulièrement réparties le long d'une ligne courbe fermée.

Selon un mode de réalisation, l'excroissance comprend une ouverture configurée pour recevoir des bornes de l'équipement électrique et chaque conducteur électrique a une portion s'étendant le long de l'ouverture de sorte que sa ou ses deuxièmes bornes débouche dans ladite ouverture.

Selon un mode de réalisation, les deuxièmes bornes sont alignées et régulièrement réparties suivant une ligne courbe ouverte.

Selon un mode de réalisation, l'excroissance comprend un décrochement définissant une zone libre de matière dans l'excroissance ; et les deuxièmes bornes des conducteurs électriques débouchent dans ledit décrochement.

L'invention concerne aussi un ensemble électrique comprenant :
- un module électronique de puissance selon l'invention,
- une machine électrique tournante ayant une pluralité de bornes de phase,
dans lequel les bornes de phase de la machine sont alignées suivant une ligne courbe de manière à venir respectivement en vis-à-vis des deuxièmes bornes des conducteurs électriques pour une connexion électrique.

Selon un mode de réalisation, les bornes de phase sont positionnées suivant une circonférence autour de l'axe de rotation de la machine ; et les premières bornes des conducteurs électriques sont positionnées à une distance radiale par rapport à l'axe de rotation qui est différente d'une distance radiale de la dite circonférence par rapport à l'axe de rotation, les conducteurs électriques s'étendant de sorte que leurs deuxièmes bornes viennent au niveau de la dite circonférence en vis-à-vis des bornes de phase pour y être directement connectées.

Selon un mode de réalisation, la portion du module électronique de puissance comprenant les puces semi-conductrices est positionnée à une distance radiale supérieure à la dite circonférence.

Selon un mode de réalisation, l'axe de rotation de la machine passe dans l'ouverture ou dans le décrochement de l'excroissance.

Selon un mode de réalisation, le module électronique de puissance est supporté par une surface, dite surface de support, ladite surface de support étant perpendiculaire à l'axe de rotation de la machine.

L'invention concerne également un compresseur de suralimentation électrique, notamment pour véhicule automobile, comprenant :
- un ensemble électrique selon l'invention ;
- une roue de compression de gaz configurée pour être entrainée par la machine électrique de l'ensemble électrique ;
- un convertisseur de tension configuré pour alimenter ladite machine électrique à partir d'un réseau électrique, ledit convertisseur de tension comprenant ledit module électronique de puissance de l'ensemble électrique

L'invention sera mieux comprise en faisant référence aux dessins, dans lesquels :
- la figure 1, déjà décrite, illustre un module électronique de puissance selon l'art antérieur ;
- les figures 2 et 3 illustrent un ensemble comprenant un module électronique de puissance selon un mode de réalisation de l'invention et une machine électrique ;
- la figure 4 illustre un exemple de compresseur de suralimentation électrique comprenant l'ensemble illustré en figures 2 et 3 ;
- les figures 5 et 6 illustrent un module électronique de puissance selon un autre mode de réalisation de l'invention ;
- la figure 7 illustre un exemple de compresseur de suralimentation électrique comprenant l'ensemble illustré en figures 5 et 6.

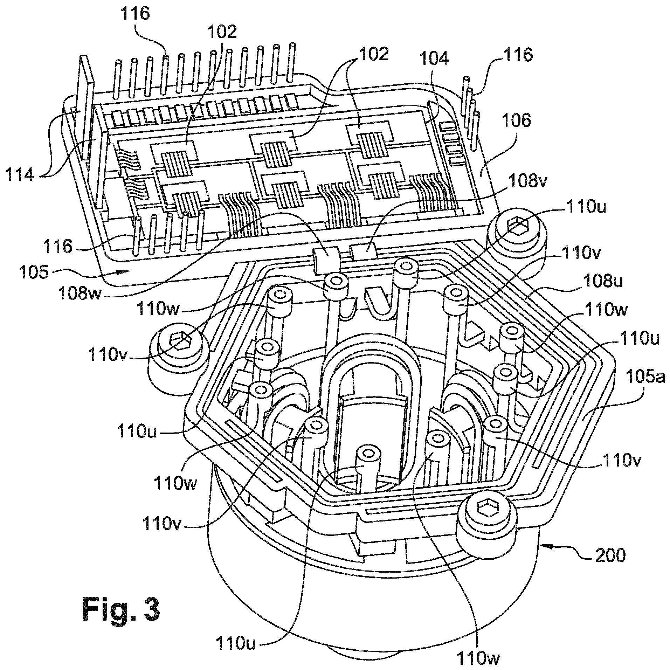

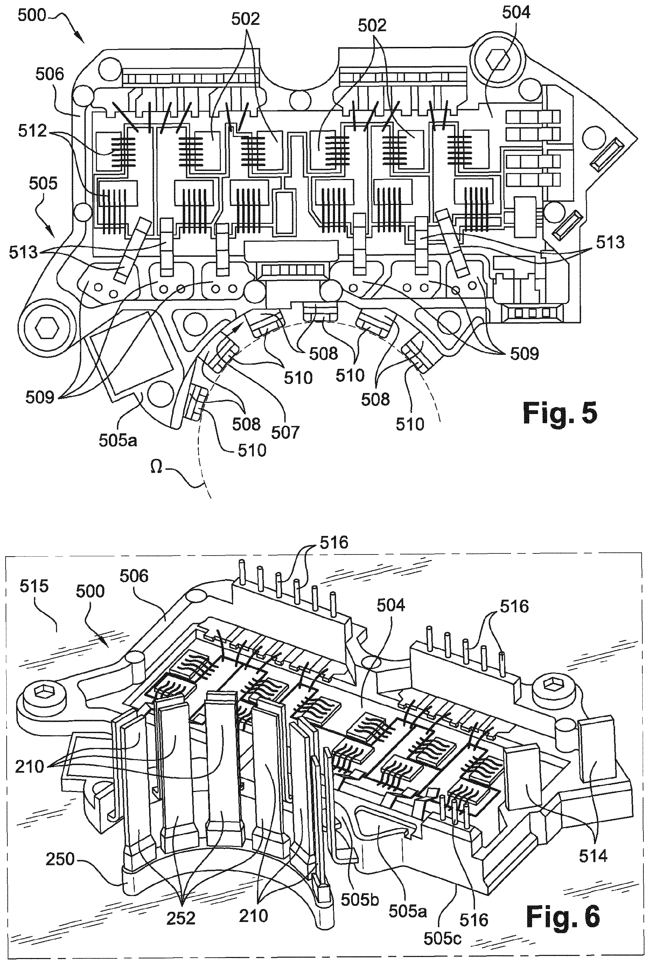

Les figures 2, 3 illustrent un premier exemple de module électronique 100 selon un mode de réalisation ; et les figures 5, 6 illustrent un deuxième exemple de module électronique 500 selon un mode de réalisation.

Le module électronique de puissance 100, 500 comprend des puces semi-conductrices 102, 502 qui commandent et échangent une énergie électrique avec un équipement électrique 200 extérieur au module électronique de puissance 100, 500. Les puces semi-conductrices 102, 502 sont notamment des interrupteurs semiconducteurs, tels que par exemple des transistors MOSFET ou IGBT. En particulier, les puces semi-conductrices 102,502 sont agencées en un circuit électronique pour commander l'énergie échangée avec l'équipement électrique 200.

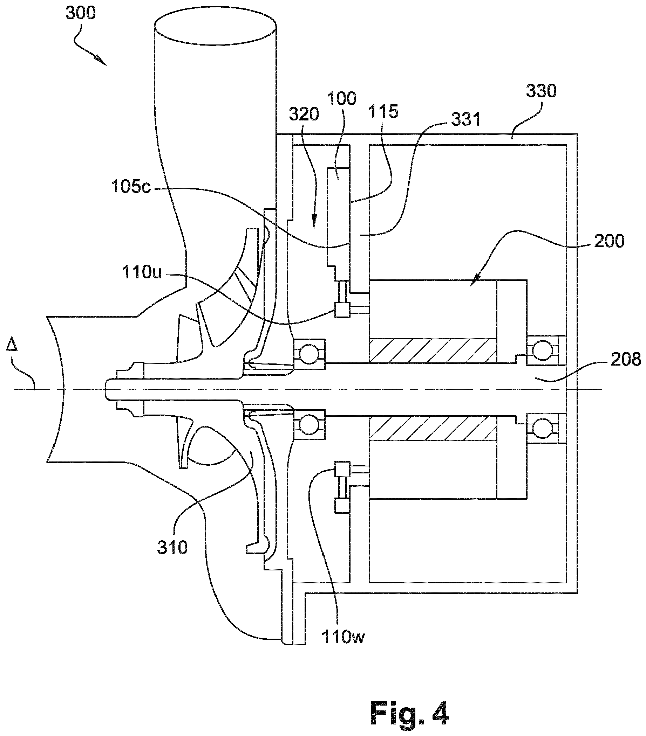

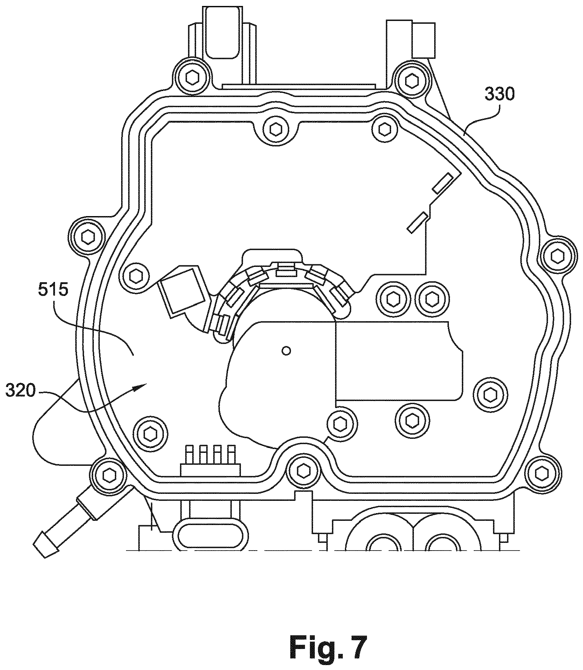

Les puces semi-conductrices 102, 502 sont contenues dans un même boitier 105, 505. Le boitier 105, 505 réalise l'encapsulation, hermétique ou non hermétique, des puces semi-conductrices 102, 502. Ainsi, le boitier 105, 505 permet de protéger les puces semi-conductrices de l'environnement extérieur. En outre, le boitier 105, 505 permet de connecter les puces semi-conductrices à des circuits électriques extérieurs au module électronique de puissance 100, 500. Le boitier 105, 505 peut permettre une évacuation de la chaleur générée par les puces semi-conductrices 102, 502, notamment par une surface sur laquelle sont montées les puces semi-conductrices 102. Le module électronique de puissance 100, 500 est notamment posé sur une surface 115, 515 de support par l'intermédiaire d'une face extérieure 105c, 505c du boitier 105, 505, par exemple comme illustré en figures 4 ou 7. Ce support peut avoir une fonction de dissipation thermique.

Notamment, les puces semi-conductrices 102, 502 peuvent être montées sur un même substrat 104, 504 appartenant au boitier 105, 505. Cette face extérieure 105c, 505c du boitier 105, 505 peut alors correspondre à une surface du substrat 104, 504 opposée à la surface sur laquelle sont montées les puces semi-conductrices 102, 502. En particulier, le substrat 104, 504 peut être formé de couches superposées isolante et/ou conductrice. Ces couches se superposent notamment de sorte que les puces semi-conductrices 102, 502 sont montées sur une des couches, en particulier sur une surface perpendiculaire à la direction de superposition des couches. Par exemple, le substrat 104, 504 est un substrat à connexion directe en cuivre ou DBC (pour « Direct bonded copper » en anglais) connu en soi. Alternativement, le substrat 104, 504 peut être formé de lames conductrices électriquement qui s'étendent côte à côte suivant un même plan et maintenues ensemble par un surmoulage en matériau isolant électrique, par exemple du plastique. Par exemple, le substrat 104, 504 peut être tel que celui divulgué dans la publication de demande de brevet européen EP1454516A.

Notamment, les puces semi-conductrices 102, 502 peuvent être montées sur une couche du substrat 104, 504 comprenant des parties séparées en un matériau conducteur électriquement, tel que du cuivre. Notamment, les puces semi-conductrices 102, 502 sont montées sur des parties en matériau conducteur électriquement. Des fils électriques 112, 512 peuvent faire la liaison électrique entre les puces semi-conductrices 102, 502 et une autre partie en matériau conducteur électriquement de la couche.

Le boitier 105, 505 peut délimiter un espace interne dans lequel sont logées les puces semi-conductrices 102, 502. Notamment, le boitier peut comprendre une ceinture 106, 506 positionnée en périphérie du substrat 104, 504. En particulier, la ceinture 106, 506 forme une paroi en périphérie du substrat 104, 504, notamment sur un bord périphérique du substrat 104, 504. Cette paroi peut être continue sur la périphérie du substrat 104, 504. La ceinture 106, 506 est notamment surmoulée sur la périphérie du substrat 104, 504 ou collée, ou maintenue par d'autres moyens mécaniques. La ceinture 106, 506 peut être aussi intégrale avec le substrat 104, 504. La ceinture 106, 506 est en particulier en un matériau isolant électriquement tel que du plastique. Notamment, la ceinture 106, 506 est sur la périphérie du substrat 104, 504 de manière à définir un logement interne recevant les puces semi-conductrices 102, 502. Ce logement défini par la ceinture 106, 506 peut être rempli par de la résine ou du gel pour protéger les composants du module électronique de puissance 100, 500.

Le boitier peut être obtenu aussi par un moulage par compression-transfert ( ou « transfer molding process » en anglais).

Le module électronique de puissance 100, 500 comprend des conducteurs électriques 108u, 108v, 108w, 508 pour permettre une connexion électrique entre les puces semi-conductrices 102, 502 du module électronique de puissance 100, 500 et l'équipement électrique 200. Sur les figures 2 et 3, des vues partiellement en coupe du boitier 105 et de son excroissance 105a sont représentées pour rendre visible les conducteurs électriques 108u, 108v, 108w. Les conducteurs électriques 108u, 108v, 108w, 508 reçoivent un courant électrique échangé entre les puces semi-conductrices 102, 502 et l'équipement électrique 200 grâce à de premières 109u, 109v, 109w, 509 et deuxièmes 110u, 110v, 110w, 510 bornes.

Les premières bornes 109u, 109v, 109w, 509 sont à l'intérieur du boitier 105, 505 et sont configurées pour être connectées à au moins une des puces semi-conductrices 102, 502. Notamment, des fils électriques 112 ou des rubans 513 peuvent permettre de connecter les premières bornes 109u, 109v, 109w, 509 des conducteurs électriques 108u, 108v, 108w, 508 avec les composants à l'intérieur du module électronique de puissance 100, 500. Les puces semi-conductrices 102, 502 peuvent être aussi montées directement sur une portion des conducteurs électriques 108u, 108v, 108w, 508 au niveau des premières bornes 109u, 109v, 109w, 509. Les deuxièmes bornes 110u, 110v, 110w, 510 sont à l'extérieur du boitier 105 et sont configurées pour être connectées à l'équipement électrique 200.

Notamment, les conducteurs électriques 108u, 108v, 108w, 508 sont d'un seul tenant, en particulier en forme de lame conductrice électriquement. Les conducteurs 108u, 108v, 108w, 508 peuvent s'étendre depuis un même côté du boitier 105, 505. Le nombre de conducteurs électriques 108u, 108v, 108w, 508 peut varier en fonction du circuit électrique formé par les puces semi-conductrices 102, 502 et/ou en fonction du nombre de bornes 210 de l'équipement électrique 200. Par exemple, le module électronique de puissance 100, 500 comprend au moins trois, voire quatre conducteurs électriques 108u, 108v, 108w, 508. Dans l'exemple illustré en figures 2 et 3, le module électronique de puissance 100 comprend trois conducteurs électriques 108u, 108v, 108w. Dans l'exemple illustré en figures 5 et 6, le module électronique de puissance 500 comprend six conducteurs électriques 508. Cependant, ces exemples de module électronique de puissance 100, 500 pourraient comprendre un nombre différent de conducteurs électriques 108u, 108v, 108w, 508.

Les conducteurs électriques 108u, 108v, 108w, 508 s'étendent à l'extérieur du boitier 105, 505 de sorte que leurs deuxièmes bornes 110u, 110v, 110w, 510 sont alignées suivant une ligne courbe Ω. Un tel agencement des deuxièmes bornes 110u, 110v, 110w, 510 est particulièrement avantageux lorsque le module électronique de puissance 100, 500 est connecté avec des bornes 210 d'un équipement électrique 200 dans lequel les bornes 210 de l'équipement électrique 200 sont agencées autour d'un axe Δ de l'équipement électrique 200, en particulier le long d'une ligne correspondant avec la ligne courbe Ω. Ainsi, lorsque le module électronique de puissance 100, 500 est connecté avec l'équipement 200, les deuxièmes bornes 110u, 110v, 110w, 510 viennent en vis-à-vis des bornes 210 de l'équipement électrique pour y être reliées. Contrairement à l'art antérieur, il n'est pas nécessaire d'utiliser un connecteur intermédiaire pour franchir une distance séparant les bornes 210 des deuxièmes bornes 110u, 110v, 110w, 510 destinées à y être connectées. La ligne courbe Ω peut correspondre à une ligne circulaire ou ellipsoïdale, ou à une portion d'une ligne circulaire ou ellipsoïdale, suivant l'agencement des bornes 210 de l'équipement électrique 200.

En particulier, le module électronique de puissance 100, 500 peut comprendre une excroissance 105a, 505a qui s'étend vers l'extérieur du module électronique de puissance 100, 500. L'excroissance 105a, 505a comprend une portion de chaque conducteur électrique 108u, 108v, 108w, 508. Ainsi, l'excroissance 105a, 505a permet de maintenir les conducteurs électriques 108u, 108v, 108w, 508 jusqu'aux deuxièmes bornes 110u, 110v, 110w, 510, ce qui améliore la tenue mécanique des conducteurs électriques 108u, 108v, 108w, 508. Les conducteurs électriques 108u, 108v, 108w, 508 sont notamment maintenus par l'excroissance 105a, 505a par surmoulage. En particulier, la portion respective des conducteurs électriques 108u, 108v, 108w, 508 qui est comprise dans l'excroissance 105a, 505a est comprise ente leur première borne 109u, 109v, 109w, 509 et leurs deuxièmes bornes 110u, 110v, 110w, 510.

En particulier, cette excroissance 105a, 505a s'étend principalement suivant un plan parallèle à la face extérieure 105c, 505c du boitier 105, 505. Cet agencement est particulièrement avantageux, dans des exemples d'ensemble illustrés en figures 4 et 7, où la face extérieure 105c, 505c du boitier 105, 505 est positionnée sur une surface 115, 515 à travers laquelle les bornes 210 de l'équipement électrique 200 passent par une ouverture. L'excroissance 105a, 505a permet d'acheminer les conducteurs électriques 108u, 108v, 108w, 508 vers une zone où ils seront connectés à des bornes 210 respectives de l'équipement électrique 200. Ainsi, Les deuxièmes bornes 110u, 110v, 110w, 510 des conducteurs électriques 108u, 108v, 108w, 508 sont déportées à distance du reste du boitier 105, 505 pour être reliés directement aux bornes 210 de l'équipement électrique 200.

Notamment, les deuxièmes bornes 110u, 110v, 110w, 510 s'étendent depuis une paroi 105b, 505b de l'excroissance 105a, 505a. Dans l'exemple illustré en figures 2 et 3, la paroi 105b depuis laquelle s'étendent les deuxièmes bornes 110u, 110v, 110w a plusieurs faces qui sont tangentes à la ligne courbe Ω. Dans l'exemple illustré en figures 5 et 6, la face de la paroi 505b depuis laquelle s'étendent les deuxièmes bornes 510 s'étend le long d'une ligne courbe. En particulier, la face de la paroi 505b a une allure générale correspondant à une ligne courbe avec quelques irrégularités liées au maintien des conducteurs 508 dans l'excroissance 505a.

Le module électronique de puissance 100, 500 peut comprendre également d'autres conducteurs électriques pour une connexion électrique entre les composants à l'intérieur du boitier 105, 505 et l'extérieur du boitier 105, 505. Par exemple, le boitier 105, 505 peut comprendre des conducteurs électriques d'alimentation de puissance 114, 514 qui vont être connectés avec une source d'énergie électrique destinée à fournir l'énergie électrique pour l'équipement électrique 200. Le boitier 105, 505 peut comprendre des conducteurs électriques 116, 516 pour un échange de signaux électriques de contrôle ou de mesure de paramètre physique ou électrique avec une unité de contrôle du module électronique de puissance 100, 500, telle qu'une carte de contrôle par exemple. En particulier, la ceinture 106, 506 comprend les conducteurs électriques 116, 516.

Dans l'exemple illustré en figures 2 et 3, la ligne courbe Ω est une ligne fermée le long de laquelle les deuxièmes bornes 110u, 110v, 110w sont régulièrement réparties. Ainsi, le module électronique de puissance 100 est particulièrement adapté pour l'alimentation électrique d'un équipement électrique 200 dans lequel les bornes 210 sont positionnées autour d'un axe Δ de l'équipement électrique 200 à des intervalles angulaires réguliers. La ligne courbe Ω est par exemple une ligne circulaire ou ellipsoïdale, notamment centrée sur l'axe Δ de l'équipement électrique 200.

L'excroissance 105a peut comprendre une ouverture 107 qui reçoit les bornes 210 de l'équipement électrique 200. En particulier, chaque conducteur électrique 108u, 108v, 108w a une portion qui s'étend le long de l'ouverture 107. Les deuxièmes bornes 110u, 110v, 110w s'étendent depuis cette portion des conducteurs électriques 108u, 108v, 108w pour déboucher dans l'ouverture 107. La paroi 105b de l'excroissance 105a depuis laquelle s'étendent les conducteurs 108u, 108v, 108w est donc une paroi interne de l'excroissance 105a. Cet agencement de l'excroissance 105a permet de maintenir les conducteurs électriques 108u, 108v, 108w au plus proche des deuxièmes bornes 110u, 110v, 110w, à proximité de la ligne courbe Ω. Ainsi, le maintien, la manipulation du module électronique de puissance 100 et la connexion des deuxièmes bornes 110u, 110v, 110w avec les bornes 210 de l'équipement électrique 200 en sont facilités. Cette ouverture 107 peut constituer un trou traversant apte à recevoir un arbre de l'équipement électrique 200, ce qui améliore l'intégration du module électronique de puissance 100 dans l'ensemble le comprenant, comme il sera décrit plus loin.

Dans l'exemple illustré en figures 5 et 6, la ligne courbe Ω est une ligne ouverte le long de laquelle les deuxièmes bornes 510 sont régulièrement réparties. Cet agencement est particulièrement adapté à un équipement électrique 200 dans lequel les bornes 210 de l'équipement électrique sont positionnées autour d'un axe Δ de l'équipement électrique 200 sur une portion angulaire limitée autour de l'axe Δ de l'équipement électrique 200. La ligne courbe Ω est par exemple une portion d'une ligne circulaire ou ellipsoïdale, notamment centrée sur l'axe Δ de l'équipement électrique 200.

L'excroissance 505a peut comprendre un décrochement 507. Ce décrochement 507 définit une zone libre de matière dans l'excroissance 505a dans laquelle les deuxièmes bornes 510 des conducteurs électriques 508 débouchent. La paroi 505b de l'excroissance 505a depuis laquelle s'étendent les conducteurs 508 est donc une paroi externe de l'excroissance 505a. Les bornes 210 de l'équipement électrique 200 sont notamment reçues dans la zone libre définie par le décrochement 507. Ce décrochement 507 permet de positionner le module électronique de puissance 500 au plus proche des bornes 210 de l'équipement électrique 200.

Les deuxièmes bornes 110u, 110v, 110w, 510 des conducteurs électriques 108u, 108v, 108w, 508 peuvent notamment comprendre une forme correspondant aux bornes 210 de l'équipement électrique 200. Par exemple, comme illustré en figures 2 et 3, lorsque l'équipement électrique consiste en une machine électrique, les deuxièmes bornes 110u, 110v, 110w peuvent avoir une forme correspondant aux extrémités des enroulements de la machine électrique pour être directement connectées aux bornes de la machine, ces bornes étant formées par les extrémités des enroulements de phase. Notamment, chaque borne correspond à l'extrémité d'une bobine d'un enroulement de phase. Les deuxièmes bornes 110u, 110v, 110w sont par exemple connectées avec les bornes de l'équipement électrique 200 par sertissage, brasage ou soudage. Par exemple, comme illustré en figures 5 et 6, les faces des deuxièmes bornes 510 destinées à venir en contact avec les bornes de l'équipement électrique peuvent être respectivement tangentes à la ligne courbe Ω suivant laquelle les deuxièmes bornes 510 sont alignées. Lorsque l'équipement électrique consiste en une machine électrique, un dispositif de connexion électrique 250 peut comprendre des premières bornes connectées aux extrémités des enroulements de la machine et de deuxièmes bornes 252 qui réalisent les bornes 210 de la machine. Ce dispositif de connexion 250 permet de ramener les bornes de la machine sur une portion angulaire limitée autour de l'axe Δ de la machine électrique. Cependant, l'exemple illustré en figures 2 et 3 pourrait se connecter avec les bornes d'un dispositif de connexion similaire qui ramène les bornes de la machine à une distance radiale différente de celle des extrémités des enroulements. Cependant, les deuxièmes bornes 510 de l'exemple illustré en figures 5 et 6 pourraient avoir une forme correspondant aux extrémités des enroulements de la machine électrique. Ce serait le cas par exemple si les extrémités des enroulements étaient déformées pour être ramenées sur une portion angulaire autour de l'axeΔ de la machine électrique. De même, les deuxièmes bornes 110u, 110v, 110w de l'exemple illustré en figures 2 et 3 pourraient être similaires à celles de l'exemple illustré en figures 5 et 6. Ce serait le cas par exemple si un dispositif de connexion ramenait les bornes de la machine électrique à une distance radiale différente de celle des extrémités des enroulements de la machine.

Par exemple, l'équipement électrique est une machine électrique tournante 200. La machine électrique 200 peut être par exemple une machine à aimant permanent ou une machine à reluctance variable. La machine électrique 200 peut comporter plusieurs enroulement de phase 201, 202, 203, 204, 205, 206, par exemple six enroulements de phase. Notamment, chaque conducteur électrique 108u, 108v, 108w, 508 peut correspondre à une phase de la machine électrique 200. Les bornes de phase 210 de la machine 200 sont alignées suivant une ligne courbe de manière à venir respectivement en vis-à-vis des deuxièmes bornes 110u, 110v, 110w, 510 des conducteurs électriques 108u, 108v, 108w, 510 pour une connexion électrique.

Les bornes de phase 210 de la machine électrique 200 peuvent être réalisées par les extrémités des enroulements de phase 201-206. Les extrémités des enroulements de phase 201-206 sont en particulier positionnées autour de l'axe de rotation Δ de la machine 200 à des intervalles angulaires, notamment à des intervalles angulaires réguliers. En particulier, cette disposition correspond aux emplacements des enroulements 201-206 dans la machine 200. Notamment, les extrémités des enroulements s'étendent suivant une direction parallèle à l'axe de rotation Δ de la machine 200. Cet agencement des bornes 210 simplifie l'assemblage de l'ensemble comprenant le module électronique de puissance 100, 500 et la machine 200 dans la mesure où les extrémités des enroulements 201-206 restent dans les prolongements des enroulements 201-206. Alternativement, les bornes 210 de la machine électrique 200 peuvent être réalisées par les deuxièmes bornes 252 du dispositif de connexion 250 décrit précédemment.

En particulier, les bornes de phase 210 sont positionnées suivant une circonférence autour de l'axe de rotation Δ de la machine 200. Cette circonférence désigne une ligne fermée autour de l'axe de rotation Δ de la machine 200. Les premières bornes 109u, 109v, 109w, 509 des conducteurs électriques 108u, 108v, 108w, 508 sont respectivement positionnées à une distance radiale par rapport à l'axe de rotation Δ qui est différente d'une distance radiale de la dite circonférence par rapport à l'axe de rotation Δ. Les conducteurs électriques 108u, 108v, 108w, 508 s'étendent de sorte que leurs deuxièmes bornes 110u, 110v, 110w, 500 viennent au niveau de cette circonférence en vis-à-vis des bornes de phase 210 pour y être directement connectées. Cette circonférence est par exemple un cercle ou une ellipse centrée sur l'axe de rotation Δ de la machine 200.

Dans les exemples illustrés, la portion du module électronique de puissance 100, 500 comprenant les puces semi-conductrices 102, 502 est positionnée à une distance radiale supérieure à la circonférence suivant laquelle les bornes de phase 210 sont positionnées. Ainsi, les bornes de phase 210 peuvent être proches de l'axe de rotation Δ de la machine 200. Il est plus facile de positionner le module électronique de puissance 100, 500 dans une zone extérieure à la circonférence suivant laquelle les bornes de phase 210 sont positionnées, car la place est limitée à l'intérieur de cette circonférence. C'est notamment le cas lorsque l'arbre de rotation 208 de la machine 200 passe à travers la surface 115 de support. En particulier, les premières bornes 109u, 109v, 109w, 509 sont situées à une distance radiale qui est supérieure à une distance radiale maximale de la circonférence suivant laquelle les bornes de phase 210 sont positionnées. Autrement dit, les bornes de phase 210 sont positionnées à une distance radiale par rapport à l'axe de rotation Δ de la machine électrique 200 qui est inférieure aux distances radiales des premières bornes 109u, 109v, 109w, 509 des conducteurs électriques 108u, 108v, 108w, 508.

Alternativement, les premières bornes 109u, 109v, 109w, 509 peuvent être situées à une distance radiale qui est inférieure à une distance radiale minimale de la circonférence suivant laquelle les bornes de phase 210 sont positionnées. La portion du module électronique de puissance 100, 500 comprenant les puces semi-conductrices 102, 502 est alors positionnée à une distance radiale inférieure à cette circonférence.

Lorsque la machine électrique est connectée au module électronique 100, 500, l'axe de rotation Δ de la machine 200 peut passer dans l'ouverture 107 du module électronique de puissance 100, comme illustré par exemple en figures 2, 3. L'axe de rotation Δ de la machine 200 peut passer dans le décrochement 507 du module électronique de puissance 500 illustré en figures 5 et 6, suivant la profondeur du décrochement 507. En particulier, cette ouverture 107 ou ce décrochement 507 peut constituer un passage pour l'arbre de rotation 208 de la machine 200.

La figure 4 illustre un exemple de compresseur de suralimentation électrique 300 comprenant le module électronique de puissance 100 et la machine électrique tournante 200 illustrés en figures 2 et 3. Cependant, le compresseur de suralimentation 300 pourrait comprendre un module électronique de puissance tel qu'illustré en figures 5 et 6. Notamment, le compresseur de suralimentation 300 est configuré pour être embarqué dans un véhicule pour comprimer les gaz d'admission du moteur à combustion du véhicule. En particulier, le réseau électrique est un réseau électrique du véhicule et comprend une batterie alimentant ledit réseau. Le compresseur de suralimentation 300 comprend une roue de compression 310 destinée à comprimer l'air d'admission d'un moteur à combustion en association duquel le compresseur de suralimentation 300 est monté. La roue de compression 310 est entrainée en rotation par la machine électrique 200. Un convertisseur de tension 320 comprenant le module électronique de puissance 100 alimente la machine électrique 200 à partir d'un réseau électrique. Notamment, le compresseur de suralimentation 300 peut comprendre un boitier 330 qui comporte la roue de compression 310, la machine électrique 200 et le convertisseur de tension 320. Ce boitier 330 peut être en plusieurs parties qui se montent les unes sur les autres pour former le boitier 330. La surface 115 qui supporte le module électronique de puissance 100 est notamment perpendiculaire à l'axe de rotation Δ de la machine 200. En particulier, la surface 115 de support peut être une face d'une paroi qui sépare deux logements du boitier 330. Par exemple, la surface 115 de support peut être une face d'une paroi 331 séparant un logement du boitier 330 comprenant le convertisseur de tension 320 d'un autre logement comprenant la machine électrique 200.

La roue de compression 310 peut être au dessus du convertisseur de tension 320 comme illustré en figure 5. Autrement dit, le convertisseur de tension 320 peut être placé entre la machine électrique 200 et la roue de compression 310. Notamment, le convertisseur de tension 320 est à une position le long de l'axe de rotation Δ de la machine 200, cette position étant entre la machine électrique 200 et la roue de compression 310, c'est-à-dire entre une zone axiale correspondant à la machine électrique 200 et une zone axiale correspondant à la roue de compression 310. Cependant, l'agencement de la roue de compression 310, de la machine électrique 200 et du convertisseur de tension 320 peut être différent. Par exemple, dans l'exemple illustré en figure 7, la machine électrique 200 se trouve entre le convertisseur de tension 320 et la roue de compression 310. Le convertisseur de tension 320 est ainsi placé à une extrémité axiale du compresseur de suralimentation 300. Un capot peut venir fermer le convertisseur de tension 320 en venant en appui sur le boitier 330. La machine électrique 200 est alors à une position le long de l'axe de rotation Δ entre le convertisseur de tension 320 et la roue de compression 310, c'est-à-dire entre une zone axiale correspondant au convertisseur de tension 320 et une zone axiale correspondant à la roue de compression 310. L'exemple illustré en figure 7 comprend le module électronique de puissance 500 illustré en figure 5 et 6. Cependant, il pourrait comprendre un module électronique de puissance 100 et une machine tels qu'illustrés en figures 2 et 3, pourvu qu'une ouverture adéquate soit aménagée dans la paroi 515 pour le passage des bornes de phase 210 de la machine 200.

L'invention n'est pas limitée aux exemples décrits. En particulier, le module électronique de puissance 100, 500 pourrait être utilisé dans d'autres appareils comprenant une machine électrique tournante et un convertisseur de tension l'alimentant, tels que par exemple des alternateurs ou des alterno-démarreurs.

## Revendications

1. Module électronique de puissance (100, 500) comprenant :
- une pluralité de puces semi-conductrices (102, 502) configurées pour commander et échanger une énergie électrique avec un équipement électrique (200) extérieur au module électronique de puissance ;
- un boitier (105, 505) encapsulant lesdites puces semi-conductrices (102, 502) ;
- des conducteurs électriques (108u, 108v, 108w, 508) configurés pour recevoir un courant électrique échangé entre les puces semi-conductrices (102, 502) et l'équipement électrique (200), lesdits conducteurs électriques (108u, 108v, 108w, 508) ayant respectivement une première borne (109u, 109v, 109w, 509) à l'intérieur dudit boitier (105, 505) configurée pour être connectée à au moins une desdits puces semi-conductrices (102, 502) et une deuxième borne (110u, 110v, 110w, 510) à l'extérieur dudit boitier (105, 505) configurée pour être connectée à l'équipement électrique (200) ;
lesdits conducteurs électriques (108u, 108v, 108w, 508) s'étendant à l'extérieur dudit boitier (105, 505) de sorte que les deuxièmes bornes (110u, 110v, 110w, 510) sont alignées suivant une ligne courbe (Ω).

2. Module électronique de puissance (100, 500) selon la revendication 1, dans lequel le boitier (105, 505) comprend une excroissance (105a, 505a) s'étendant vers l'extérieur du module électronique de puissance et comprenant une portion respective des conducteurs électriques (108u, 108v, 108w, 508).

3. Module électronique de puissance (100, 500) selon la revendication 2, dans lequel lesdites deuxièmes bornes (110u, 110v, 110w, 510) s'étendent depuis une paroi (105b, 505b) de ladite excroissance (105a, 505a), ladite paroi (105b, 505b) ayant une face s'étendant le long d'une ligne courbe (Ω) ou ayant plusieurs faces tangentes à une ligne courbe (Ω).

4. Module électronique de puissance (100, 500) selon la revendication 2 ou 3, dans lequel l'excroissance (105a, 505a) s'étend principalement suivant un plan parallèle à une surface (104, 504) suivant laquelle les puces semi-conductrices (102, 502) sont montées.

5. Module électronique de puissance (100, 500) selon l'une des revendications précédentes, dans lequel les deuxièmes bornes (110u, 110v, 110w, 510) comprennent respectivement une face destinée à venir en contact avec des bornes de l'équipement électrique, ladite face étant tangente à ladite ligne courbe (Ω) suivant laquelle les deuxièmes bornes (110u, 110v, 110w, 510) sont alignées.

6. Module électronique de puissance (100) selon l'une des revendications précédentes, dans lequel les deuxièmes bornes (110u, 110v, 110w) sont alignées et régulièrement réparties le long d'une ligne courbe (Ω) fermée.

7. Module électronique de puissance (100) selon les revendications 2 et 6, dans lequel l'excroissance (105a) comprend une ouverture (107) configurée pour recevoir des bornes (210) de l'équipement électrique et chaque conducteur électrique (108u, 108v, 108w) a une portion s'étendant le long de l'ouverture (107) de sorte que sa ou ses deuxièmes bornes (110u, 110v, 110w) débouche dans ladite ouverture (107).

8. Module électronique de puissance (500) selon l'une des revendications 1 à 5, dans lequel les deuxièmes bornes (510) sont alignées et régulièrement réparties suivant une ligne courbe (Ω) ouverte.

9. Module électronique de puissance (500) selon les revendications 2 et 8, dans lequel l'excroissance (505a) comprend un décrochement (507) définissant une zone libre de matière dans l'excroissance ; et dans lequel les deuxièmes bornes (510) des conducteurs électriques (508) débouchent dans ledit décrochement (507).

10. Ensemble électrique comprenant :
- un module électronique de puissance (100, 500) selon l'une des revendications précédentes,
- une machine électrique tournante (200) ayant une pluralité de bornes de phase (210),
dans lequel les bornes de phase (210) de la machine sont alignées suivant une ligne courbe (Ω) de manière à venir respectivement en vis-à-vis des deuxièmes bornes (110u, 110v, 110w, 510) des conducteurs électriques (108u, 108v, 108w, 508) pour une connexion électrique.

11. Ensemble électrique selon la revendication précédente, dans lequel
les bornes de phase (210) sont positionnées suivant une circonférence autour de l'axe de rotation de la machine, et
les premières bornes (109u, 109v, 109w, 509) des conducteurs électriques (108u, 108v, 108w, 508) sont positionnées à une distance radiale par rapport à l'axe de rotation (Δ) qui est différente d'une distance radiale de la dite circonférence par rapport à l'axe de rotation (Δ), les conducteurs électriques (108u, 108v, 108w, 508) s'étendant de sorte que leurs deuxièmes bornes (110u, 110v, 110w, 510) viennent au niveau de la dite circonférence en vis-à-vis des bornes de phase (210) pour y être directement connectées.

12. Ensemble électrique selon la revendication 11, dans lequel la portion du module électronique de puissance (100, 500) comprenant les puces semi-conductrices (102, 502) est positionnée à une distance radiale supérieure à la dite circonférence.

13. Ensemble électrique selon l'une des revendications 10 à 12, dans lequel le module électronique de puissance (100, 500) est selon la revendication 7 ou 9, et l'axe de rotation (Δ) de la machine passe dans l'ouverture (107) ou dans le décrochement (507) de l'excroissance (105a, 505a).

14. Ensemble électrique selon l'une des revendications 10 à 13, dans lequel le module électronique de puissance (100, 500) est supporté par une surface (115, 515), dite surface de support, ladite surface de support étant perpendiculaire à l'axe de rotation (Δ) de la machine.

15. Compresseur de suralimentation électrique (300), notamment pour véhicule automobile, comprenant :
- un ensemble électrique selon l'une des revendications 10 à 14 ;
- une roue de compression de gaz (310) configurée pour être entrainée par la machine électrique (200) de l'ensemble électrique ;
- un convertisseur de tension (320) configuré pour alimenter ladite machine électrique (200) à partir d'un réseau électrique, ledit convertisseur de tension (320) comprenant ledit module électronique de puissance (100, 500) de l'ensemble électrique.
